Europäisches Patentamt

European Patent Office

Office européen des brevets

(19)

(11) **EP 1 473 828 A1**

(12) **EUROPEAN PATENT APPLICATION**

(43) Date of publication:
**03.11.2004 Bulletin 2004/45**

(51) Int Cl.⁷: **H03D 13/00**, H03L 7/085,
H04L 7/033

(21) Application number: **03425274.2**

(22) Date of filing: **30.04.2003**

| (84) Designated Contracting States: | • **Pozzoni, Massimo** |
|---|---|
| **AT BE BG CH CY CZ DE DK EE ES FI FR GB GR HU IE IT LI LU MC NL PT RO SE SI SK TR** Designated Extension States: **AL LT LV MK** | **27100 Pavia (IT)** • **Scotti, Giuseppe** **04100 Latina (IT)** • **Trifiletti, Alessandro** **00049 Velletri (IT)** |
| (71) Applicant: **STMicroelectronics S.r.l.** **20041 Agrate Brianza (Milano) (IT)** | (74) Representative: **Pellegri, Alberto et al** **c/o Società Italiana Brevetti S.p.A.** **Piazza Repubblica, 5** **21100 Varese (IT)** |
| (72) Inventors: • **Centurelli, Francesco** **00162 Roma (IT)** | |

(54) **Phase detector and method of generating a differential signal representative of a phase-shift**

(57)    A phase detector input with a generally oscillating signal, and with a clock signal for outputting a differential signal representing the phase difference between the oscillating signal and the clock signal, comprises

- a first differential pair of transistors (Q3,Q4) driven by the clock signal and by its inverted replica (CK and CKN) for generating the differential signal (OUT+,OUT-) corresponding to the currents respectively flowing in the transistors of the first differential pair;
- at least an auxiliary differential pair of transistors (Q1,Q2) driven by the oscillating signal and its inverted replica (DAT and DATN) having its common current node coupled to corresponding current nodes of the first differential pair;
- a current generator (Ipd) biasing all the differential pairs.

If there are long periods of time during which the oscillating signal does not switch, the precision of the frequency of the recovered clock may worsen progressively. This problem is solved by providing the phase detector with a feedback loop for regulating the current delivered by the current generator that monitors the transition density of the generally oscillating input signal and increases the bias current of the differential pairs when the transition density decreases. The output differential signal is thus generated with a greater gain thus making the VCO that is present downstream, adjust more promptly the frequency of the recovered clock.

FIG. 5

EP 1 473 828 A1

**Description**

FIELD OF THE INVENTION

The present invention relates to phase detectors and in particular to a method of generating a differential signal representing the phase difference between two input signals and very simple phase detectors particularly suited to work at high frequencies.

BACKGROUND OF THE INVENTION

In long distance transmission systems operating at high bit rates over standard signal fiber lines, data receivers may receive significantly distorted signals. Intersymbolic interference, finite bandwidth, fiber nonlinearity and other non-idealities increase the probability of erroneous recognition of a received bit. For these reasons, it is often necessary to place, along the transmission line, data regenerating channel systems that sample a received signal and retransmit it to either a successive data regenerating system or to the end receiver.

The incoming data at the receiver may be considered as a varying analog signal from which a synchronism or clock signal may be recovered. Recovering the clock in the form of a signal that generally oscillates between a higher level and a lower level signal from the incoming signal is essential for sampling it correctly to regenerate the digital data to be transmitted.

Of course, the clock signal could alternatively be transmitted together with the data stream and the clock be easily filtered at the receiver, in the majority of cases though it must be recovered from the data stream, commonly by the use of a so-called phase locked loop (PLL).

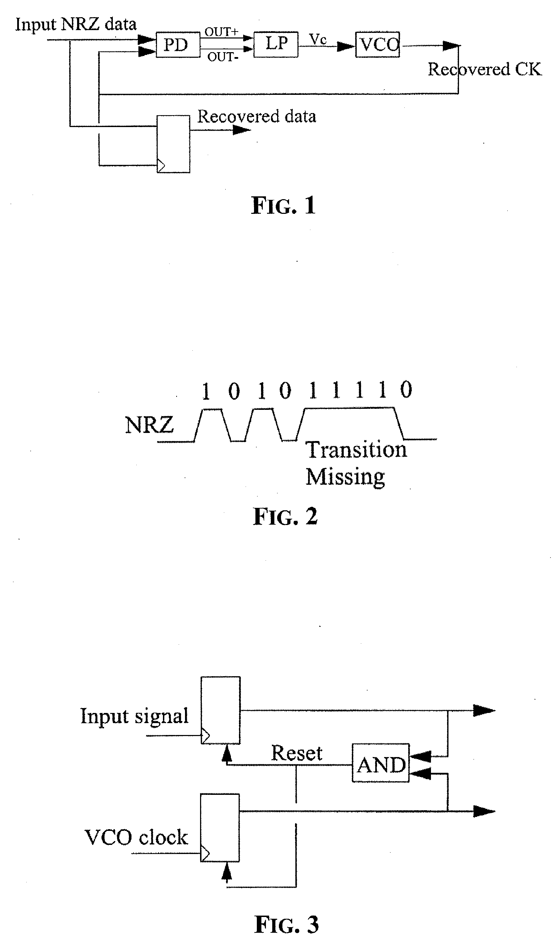

Figure 1 shows a sample architecture of a system for data regeneration. It is substantially composed of a phase-locked loop, which includes a phase detector PD, a loop filter LP and a voltage controlled oscillator VCO. The loop recovers the clock signal CK and provides it to a D-type flip-flop that samples the input signal for outputting a regenerated data stream.

The phase detector PD is input with the digital signal DAT to be regenerated and retransmitted and the recovered clock CK, and commonly includes a differential stage that outputs a differential signal OUT+, OUT- representing the phase difference between the digital signal DAT and the clock CK. This differential signal is produced by comparing the transition edges of the digital signal and of the clock signal.

The loop filter LP is input with the differential signal OUT+, OUT- and generates a control voltage Vc of a voltage controlled oscillator VCO by low pass filtering the differential component of the differential signal OUT+, OUT-. If the control voltage Vc is not null, the VCO adjusts the frequency of the so recovered clock CK until the control voltage becomes null.

If the digital signal DAT switches regularly, the phase detector is able to continuously compare the transition edges of the recovered clock and of the signal DAT and thus the recovered clock has a good precision. Differently, when the digital signal is a so-called Non-Return to Zero (NRZ) signal, such as the one depicted in Figure 2, there may not be transitions for a relatively long time, and during those intervals the PLL loop is no longer able to adjust the frequency of the recovered clock.

Many types of phase detectors are available. Among the most diffused ones, it is worth mentioning the classical phase and frequency detector (PFD), the "bang-bang" detector and the linear phase detector.

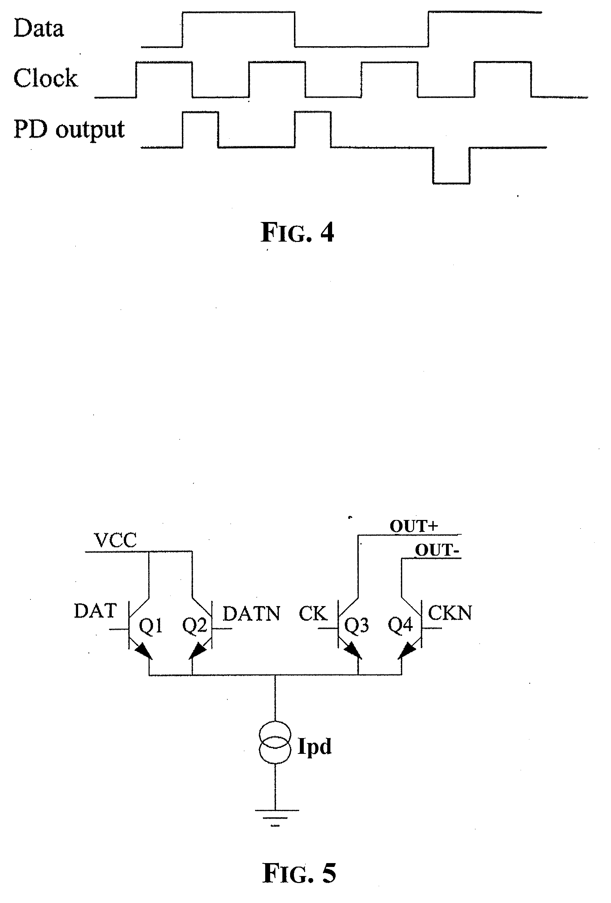

The PFD detector, shown in Figure 3, is most commonly used in PLL systems because of its capability of detecting both phase and frequency errors. It comprises two D-type flip-flops, the first clocked by the input signal and the second by the recovered clock generated by the voltage controlled oscillator VCO of the phase-locked loop. When one of these signals undergo a transition, the output of the respective flip-flop is set. The two flip-flops may be reset only when both are set.

In this mode the flip-flops generate two output pulses, and the difference between the duration of these two pulses represents the phase error between the two input signals.

The advantage of this detector consists in its capability of sensing both phase errors and frequency errors and in the fact that its output is proportional to the phase mismatch. A second advantage consists in the fact that when the two inputs are synchronized, the duration of the output pulses is null and there is no injection into the loop filter and, as a consequence, a minimized jitter.

A disadvantage of this architecture is that it does not work in case of absence of transitions in the input signal and so it is not usable for regenerating data of a NRZ transmission system.

A possible solution to overcome this limitation is represented by the so-called "bang-bang" phase detector, the working principle of which is illustrated by the time diagram of Figure 4.

If a data transition occurs before a clock transition, then this phase detector outputs a fixed-length positive pulse to the loop filter in cascade, while in the opposite case, that is when a data transition occurs after the clock transition, a negative fixed-length pulse value is generated.

The disadvantage of this phase detector consists in the fact that its output is not proportional to the phase error between data and clock, i.e. this phase detector has a non-linear transfer function. A system for regenerating data that employs a bang-bang phase detector may continuously oscillate between a phase lead and a phase lag, increasing the frequency jitter of the recovered clock.

Another family of phase detectors is represented by the linear phase detectors like the Hogge phase detectors, that generate a signal proportional to the phase difference of their input signals. Both linear and bang-bang phase detectors exploit a similar working principle: at the transition of the incoming data, a positive or negative current or voltage pulse is output toward the loop filter, depending on the fact that the data lead or lag the clock. The amplitude of the pulse may be constant (bang-bang phase detectors) or proportional (linear phase detectors) to the phase difference between the data and the clock [1]. Unfortunately, it is very difficult to use them when the data rate is relatively high because they are based on the use of flip-flops, which require a certain time for generating a stable output.

## OBJECT AND SUMMARY OF THE INVENTION

It has been found and is the object of the present invention an outstandingly fast and relatively simple phase detector, which may be used in a phase-locked loop, particularly suited for operating at relatively high data rates by virtue of the fact that it is based on the use of fast linear (analog) stages.

More precisely, object of the present invention is a phase detector input with a generally oscillating signal, for example a more or less distorted digital data signal, and with a clock signal for outputting a differential signal representing the phase difference between the oscillating signal and the clock signal, comprising

- a first differential pair of transistors respectively driven by the clock signal and by its inverted replica for generating a differential signal corresponding to the currents respectively flowing in the transistors of the first differential pair;
- at least an auxiliary differential pair of transistors respectively driven by the generally oscillating signal and its inverted replica having its common current node coupled to corresponding current nodes of the first differential pair;
- a current generator biasing all the differential pairs.

The output differential signal is non-null only when there is a transition and there is a phase difference. For the time the oscillating input signal does not undergo any transition, the differential signal remains null.

Though the novel phase detection of this invention is outstandingly fast, as in known phase detectors, also in a phase detector of this invention, if there are long periods of time during which the generally oscillating signal does not switch, the precision of the frequency of the recovered clock may worsen progressively.

According to a preferred embodiment of this invention, the above mentioned problem is solved by providing the phase detector with a feedback loop that regulates the current generated by the biasing current generator. The loop includes a sensor that monitors the transition density of the generally oscillating input signal and increases the bias current of the differential transistor pairs when the transition density decreases. The amplitude of the output differential signal increases because of the increased gain of the differential stage thus making the VCO that is present downstream, adjust more promptly the frequency of the recovered clock.

It has been found that the transition density of the oscillating input signal directly affects the time average of the common mode current of the output differential signal, and that an effective feedback loop may be simply realized by using a sensing circuit of the output common mode current for generating a voltage representative of the transition density of the input oscillating signal, and a correction circuit, including an amplifier of the difference between the representative voltage and a reference value, for regulating the gain of the differential pairs in order to make null this difference.

The invention is more precisely defined in the annexed claims.

## BRIEF DESCRIPTION OF THE DRAWINGS

The different aspects and advantages of the invention will appear even more evident through a detailed description of few embodiments and by referring to the attached drawings, wherein:

**Figure 1** illustrates a typical system for regenerating digital data;
**Figure 2** is a sample waveform of a Non-Return-to-Zero digital signal;
**Figure 3** depicts a phase and frequency detector PFD;
**Figure 4** shows the signal waveforms of a "bang-bang" phase detector;
**Figure 5** shows a basic architecture of a first embodiment of a phase detector made in accordance with this invention;
**Figure 6** shows an alternative embodiment of a phase detector of this invention;

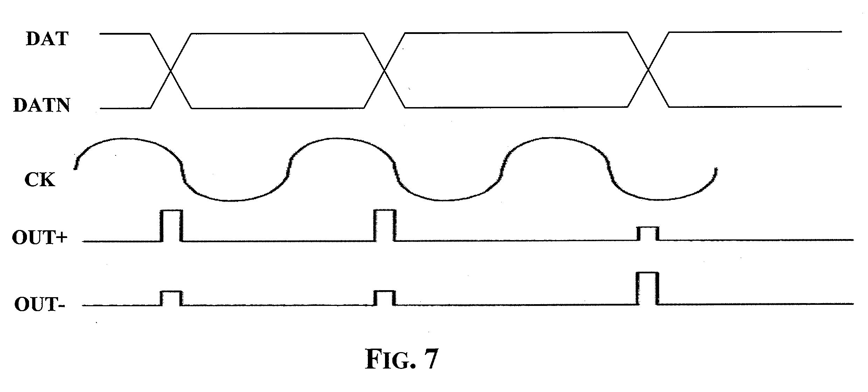

**Figure 7** is a time diagram illustrating the functioning of the phase detectors of Figures 5 and 6;
**Figure 8** depicts a preferred embodiment of the phase detector of the invention.

## DESCRIPTION OF DIFFERENT EMBODIMENTS OF THE INVENTION

A first embodiment of a phase detector of this invention is depicted in Figure 5. The phase detector is substantially composed of a first Q3 - Q4 and a second Q1 - Q2 differential pairs of transistors, biased by a common constant current generator Ipd. The first differential pair is driven by the recovered clock CK and its inverted replica CKN, while the second pair is driven by an input signal DAT and its inverted replica DATN.

[1] Aaron, Buchwald, Ken, Martin, "Integrated Fiber-Optic Receivers", Kluwer Academic Publishers.

For sake of simplicity, in the ensuing description reference will be made to a digital signal DAT, but the same considerations hold for any other generally oscillating signal, such as a sine waveform, a saw-tooth signal and the like.

The amplitudes of the signal DAT and of the recovered clock CK may be chosen such that when the digital signal DAT is not switching, the second differential pair Q1 - Q2 draws the whole current of the generator, while the first differential pair Q3 - Q4 does not deliver any output current to the loop filter. For a digital signal DAT switching between a positive +V and a negative voltage -V, this condition is satisfied if the absolute value V is always greater than the maximum absolute voltage level of the recovered clock.

The above mentioned condition is not strictly necessary. As may be easily noticed by an expert technician, the clock amplitude may even surpass the absolute value V of the oscillating input signal if the transistors Q3 - Q4 of the first differential pair are provided with appropriate emitter degeneration resistors (not shown in Figure 5). For sake of simplicity, the ensuing description refers to the case in which there are not emitter degeneration resistors.

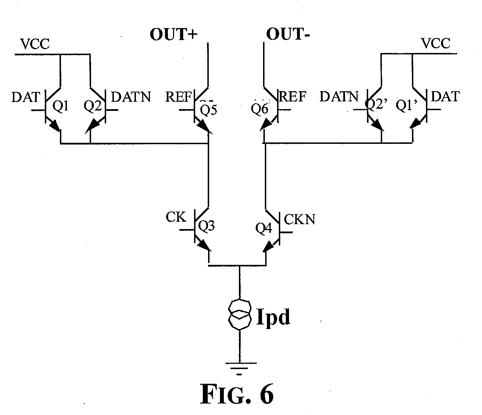

During data transition, because of finite rise and fall times of the digital signal DAT, if the recovered clock is not synchronous with the signal DAT, there will be a time interval during which the differential pair Q3 and Q4 absorbs a portion or the whole constant bias current Ipd, as illustrated in Figure 6 by way of a time diagram. When the signal DAT does not switch synchronously with the clock signal, there is a short time interval during which the clock CK (or CKN) signal is greater than or comparable to the voltage levels of the digital signal DAT and of its inverted replica DATN. During this time interval a nonnull current OUT+ or OUT- flows in the transistor Q3 or Q4.

If at a transition of DAT (DATN) the clock signal CK is higher than CKN, then the current OUT+ is greater than the current OUT-, while the opposite situation occurs when at the transition of DAT (DATN) the clock CK is lower than CKN.

By assuming that, because of finite rise and fall times of the oscillating input signal DAT and of its inverted replica DATN, there is a time interval T1 in which a part of the bias current Ipd is absorbed through the transistors Q3 and/or Q4 and that half of the bias current Ipd is absorbed through the differential pair Q1 - Q2 and half through the output differential pair Q3 - Q4, the total electrical charge flowing in the differential pair Q3 - Q4 will be

$$Ipd * T1/2$$

This charge transfer splits itself between the two transistors Q3 and Q4 according to the well known hyperbolic tangent function that characterizes every differential pair. If the phase mismatch between the recovered clock CK and the input signal DAT is relatively small, it is possible to approximate this hyperbolic function with a linear function and thus the differential output signal will be approximately proportional to the phase mismatch.

If the bases of the transistors Q3 and Q4 are at the same voltage during a transition of the signal DAT, that is if the clock is perfectly synchronous with the digital signal DAT, both transistors absorb only a common mode current, while the differential mode current, which represents the output of the phase detector, is null.

Should the base voltage of the transistor Q3 be higher (lower) than the base voltage of the transistor Q4 during a transition of the signal DAT, that is if the recovered clock CK leads (lags) the signal DAT, then a greater (smaller) current will flow in Q3 than in Q4: in this case the phase detector will output a nonnull differential signal because the two input signals are out of phase.

The fact that the amplitudes of the output current pulses OUT+ and OUT- of the phase detector of this invention are practically proportional to the delay between the clock CK and the signal DAT, makes the phase detector particularly suited for realizing phase-locked loops that are capable of recovering accurately the clock from a NRZ data stream. In fact, the phase detector of this invention outputs a null differential signal in case of phase matching between the input signal DAT and the recovered clock, thus minimizing the frequency jitter of the recovered clock CK.

The phase detector of the present invention may work at very high bit rates (>10Gb/s) because it is substantially composed of four transistors, which may be either bipolar junction transistors (BJT) or MOSFETs, with relatively short recovery times and that may switch at extremely high frequency.

Moreover the phase detector of this invention is ideally suited also for NRZ digital input signals, because it does not generate spurious outputs in correspondence of missing transitions. In fact, as long as the signal DAT does not switch, the differential pair Q3 - Q4 that generates the differential signal OUT+, OUT- remains unable of drawing any current from the bias current generator Ipd, because the second differential pair Q1- Q2 absorbs the whole bias current of the common current generator.

According to an alternative embodiment, there may be two auxiliary differential pairs Q1 - Q2 and Q1' - Q2' coupled, respectively, to the collector nodes of the transistors Q3 - Q4 of the first differential pair, according to the circuit diagram of Figure 6, instead of only one auxiliary differential pair Q1 - Q2 connected to the common emitter node, as depicted in Figure 5. The working principle remains the same: the two differential pairs Q1 - Q2 and Q1' - Q2' are both driven by the same signals DAT and DATN and draw current from the output lines of the first differential pair Q3 - Q4, making null the differential output signal OUT+ and OUT- when the amplitude of the signal DAT or of DATN exceeds the amplitude of the clock CK and of its inverted replica CKN.

In addition, output transistors Q5 - Q6 are respectively connected in series to the collector nodes of the first differential pair and are both controlled by a control voltage REF for keeping the output transistors Q5 - Q6 in a conduction state at least and preferably only during the transitions of the input signal DAT. This may be simply ensured by choosing a control voltage REF comprised between the maximum and the minimum values of the oscillating signal DAT.

Let us suppose that the oscillating input signal DAT be a digital signal such as that of Figure 2. It may happen that the signal DAT does not undergo transitions for long periods of time, and as discussed above the precision of the frequency of the clock recovered by a PLL employing a phase detector of this invention may decrease in presence of these relatively long periods of no transitions (no oscillations of the input signal).

In order to reduce the loss of precision that may be caused by a decrease of the transition density, a phase detector with a variable gain is employed and the gain is increased as the transition density decreases. In this way, the VCO downstream of the phase detector receives a control voltage Vc of enhanced amplitude and adjusts more promptly the frequency of the recovered clock.

Accordingly, the phase detectors of this invention depicted in Figures 5 and 6 may be optionally provided with such a feedback loop composed of

- sensing means for generating a signal V2 representative of the transition density of the oscillating input signal, and
- a correction circuit, including an amplifier of the difference between the signal V2 and a certain reference value V1, that regulates the bias current Ipd to make the representative signal V2 equal to the reference value V1.

As noted several sensing means of the transition density are known and may be constituted, for example, by a counter of the clock pulses between successive transitions of the oscillating input signal and by a circuit that generates a signal V2 representative of a time average of these counts.

According to an aspect of a phase detector of this invention, employing at least a differential stage for outputting a differential current OUT+ and OUT-representative of the phase difference between the oscillating input signal DAT and the recovered clock CK, effective sensing means may be implemented in an outstandingly simple manner that simply generate a representative signal Vs in function of the time average of the output common mode current.

It has been found that, when the input signal does not switch (oscillates), the differential output signal is null and thus the time average of the output common mode decreases as the transition density decreases.

Preferably, the signal V2 representative of the transition density of the oscillating input signal DAT is obtained by low pass filtering the common mode component of the differential output signal. This signal V2 is thence compared with a reference value V1 and the gain of the phase detector is regulated a feedback mode to make the signal V2 equal to V1 by regulating the bias current of the differential pair that generates the output differential signal OUT+, OUT-.

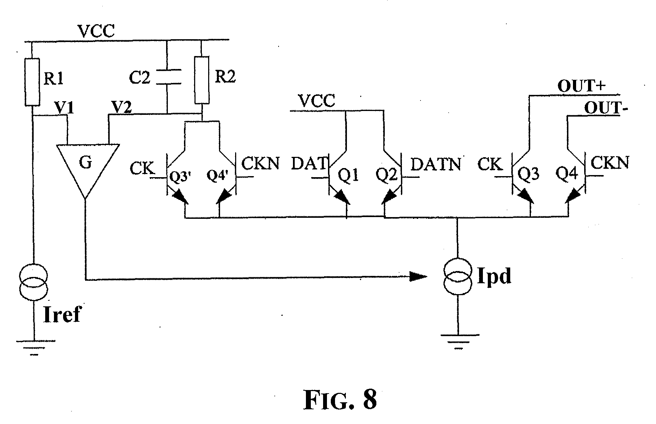

Accordingly, a preferred embodiment of the phase detector of this invention is depicted in Figure 8. The phase detector is composed of a first differential pair Q3 - Q4, controlled by the clock CK and by its inverted replica CKN, outputting the differential signal OUT+, OUT-, a second differential pair Q1 - Q2, controlled by the digital input signal DAT and by its inverted replica DATN, the two differential pairs being biased by a common current generator Ipd, the current of which is regulated by a feedback loop.

The regulation loop is implemented by adding a third differential pair of transistors Q3' - Q4' that may be identical or scaled replicas of the transistors Q3 - Q4 of the first (output) differential pair and similarly driven by CK and CKN, such that the currents flowing in the transistors Q3' and Q4' are equal or proportional to the currents flowing in the corresponding output transistors Q3 - Q4 of the first differential pair. The output common mode current flowing in the differential pair Q3' - Q4' is forced through a low pass filter R2 - C2, for generating a voltage V2 representative of the time average of the output common mode current of the phase detector and thus of the transition density of the input signal. The voltage V2 is applied to a first input of an error amplifier G to the other input of which is applied a reference voltage V1, that may be obtained by forcing a reference current Iref through a resistor R1. The error amplifier G regulates the current Ipd generated by the common bias generator of all three differential pairs to make V2 equal V1.

In presence of periods of time during which the input digital signal DAT ceases to switch, the voltage V2 on the low-pass filter R2 - C2 decreases signaling that the time average of the common mode current forced through the filter is diminishing. The high gain differential error amplifier G input with the voltages V1 and V2 regulates the current Ipd that biases all three differential pairs of transistors to make null the difference between V2 and V1.

When a transition occurs after a long sequence of substantially equal input values, the transistors Q3 and Q4 of the first differential pair result biased with a relatively enhanced bias current and the gain of the differential stage is at a correspondingly enhanced level.

Even the phase detector of Figure 6 may be provided with a feedback loop for regulating the bias current (gain) in function of the transition density. Also in this case, the sensing means may be realized very simply by employing an additional pair of transistors Q5' and Q6', identical to or scaled replicas of the output differential pair of transistors Q5 - Q6, and having their respective emitter (or source) nodes connected to the corresponding emitter (or source) nodes of the output transistors Q5 or Q6, and controlled by the same control voltage REF such that the currents flowing through the transistors Q5' and Q6' be equal or proportional to the currents flowing through the corresponding output transistors Q5 and Q6. These currents are eventually summed and forced through a low pass filter, for generating a voltage signal V2 similarly to the already described embodiment of Figure 8.

**Claims**

1. A phase detector input with a generally oscillating signal (DAT) and with a clock signal (CK) for outputting a differential signal (OUT+, OUT-) representing the phase difference between said oscillating signal (DAT) and said clock signal (CK), comprising
   a first differential pair of transistors (Q3, Q4) respectively driven by said clock signal (CK) and by its inverted replica (CKN) for generating said differential signal (OUT+, OUT-);
   at least an auxiliary differential pair of transistors (Q1, Q2) respectively driven by said oscillating signal (DAT) and its inverted replica (DATN) having its common current node connected to corresponding current nodes of the transistors (Q3, Q4) of said first differential pair; and
   a current generator (Ipd) biasing all said differential pairs.

2. The phase detector of claim 1, having two auxiliary differential pairs of transistors (Q1, Q2; Q1', Q2'), the transistors of each of said two auxiliary differential pairs respectively driven by said oscillating signal (DAT) and its inverted replica (DATN) and having their common current nodes coupled to the output nodes, respectively, of the transistors (Q3, Q4) of said first pair.

3. The phase detector of claim 2, further comprising a pair of output transistors (Q5, Q6) respectively connected to said output nodes and having their control nodes coupled to a fixed voltage (REF) comprised between the maximum and the minimum voltages of said oscillating signal (DAT).

4. A phase detector according to any of the precceding claims 1, 2 and 3, wherein said current generator (Ipd) is a regulated bias current generator, the phase detector further including a feedback loop for regulating said current generator comprising
   sensing means for generating a signal (V2) representative of the transition density of said oscillating signal (DAT), and
a bias correction circuit including an error amplifier of the difference between said generated signal (V2) and a reference voltage (V1), regulating the bias current generated by said generator (Ipd) to make null said difference.

5. The phase detector of claim 4, wherein said sensing means generate said representative signal (V2) in function of a time averaged common mode component of said differential signal (OUT+, OUT-).

6. The phase detector of claim 5, wherein said sensing means are composed of
   a replica differential pair of transistors of identical size or of a scaled size of said first differential pair (Q3, Q4), replica (CKN) and having a common current node connected to a common current node of said first differential pair (Q3, Q4);
   a low-pass filter (C2, R2) fed with the sum current flowing in the transistors of said replica differential pair, the voltage on the filter constituting said representative signal (V2).

7. The phase detector of claim 5, wherein said sensing means are composed of
   a replica differential pair of transistors of identical size or of a scaled size of said pair of output transistors (Q5, Q6), and having their control nodes coupled to said fixed voltage (REF) and having their emitter or source nodes connected to respectively connected to emitter or source nodes of corresponding transistors of said pair of output transistors (Q5, Q6);
   a low-pass filter (C2, R2) fed with the sum current flowing in the transistors of said replica differential pair, the voltage drop on the filter constituting said representative signal (V2).

8. The phase detector of claim 1, wherein the amplitude of said oscillating signal (DAT) is greater than the amplitude of said clock signal (CK).

9. The phase detector of claim 1, wherein said oscillating signal (DAT) is a digital signal switching between a positive voltage level (+V) and a negative voltage level (-V).

10. The phase detector of claim 1, wherein each differential pair of transistors is constituted by a pair of NPN bipolar junction transistors the emitters of which are connected through respective degeneration resistors.

11. The phase detector of claim 1, wherein each differential pair of transistors is constituted by a pair of MOS transistors.

**12.** A phase-locked loop comprising
a phase detector (PD) input with an oscillating signal (DAT) and a clock signal (CK) and outputting a differential signal (OUT+, OUT-) representing the phase difference between said oscillating signal (DAT) and said clock signal (CK),
a loop filter (LP) input with said differential signal (OUT+, OUT-) and generating a control voltage (VC),
a voltage controlled oscillator (VCO) controlled by said loop filter (LP) and generating said clock signal (CK) the frequency of which is proportional to said control voltage (VC),
**characterized in that** said phase detector (PD) is as defined in claim 1.

**13.** A system for regenerating data comprising
a phase-locked loop input with a digital data signal (DAT) and generating a recovered clock signal (CK) in phase with said digital signal (DAT),
a D-type flip-flop input with said digital signal (DAT) and said recovered clock signal (CK), outputting a regenerated digital data signal by sampling the digital signal (DAT) with said recovered clock signal (CK),
**characterized in that** said phase-locked loop is as defined in claim 12.

**14.** A method of generating a differential current signal (OUT+, OUT-) representative of the phase difference between a generally oscillating signal (DAT) and a clock signal (CK) applied to respective inputs of a phase detector as defined in claim 4, comprising the steps of
generating a signal (V2) representative of the transition density of said oscillating signal (DAT);
regulating the bias current (Ipd) in said differential stage to make said representative signal (V2) equal to a reference value (V1).

**15.** The method of claim 1, comprising the step of generating said representative signal (V2) in function of a time averaged common mode component of said differential current signal (OUT+, OUT-).

**FIG. 1**

**FIG. 2**

**FIG. 3**

FIG. 4

FIG. 5

**FIG. 6**

**FIG. 7**

EP 1 473 828 A1

**FIG. 8**

**European Patent Office**

## EUROPEAN SEARCH REPORT

Application Number

EP 03 42 5274

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 5 659 263 A (DOW STEPHEN W ET AL) 19 August 1997 (1997-08-19) * column 3, line 26 - column 4, line 50; figure 2 * | 1-15 | H03D13/00 H03L7/085 H04L7/033 |
| A | PAYNE A ET AL: "150-MHZ TRANSLINEAR PHASE-LOCKED LOOP" IEEE TRANSACTIONS ON CIRCUITS AND SYSTEMS II: ANALOG AND DIGITAL SIGNAL PROCESSING, IEEE INC. NEW YORK, US, vol. 45, no. 9, September 1998 (1998-09), pages 1220-1231, XP000850873 ISSN: 1057-7130 * paragraph [000C]; figure 4 * | 1-15 | |
| A | US 3 970 868 A (CLEMENTS IVOR K ET AL) 20 July 1976 (1976-07-20) * column 1, line 6 - line 36; figure 1 * | 1-5 | |
| A | US 5 781 036 A (MCCARROLL BENJAMIN J ET AL) 14 July 1998 (1998-07-14) * column 1, line 52 - line 67; figure 2 * | 4-7,14, 15 | TECHNICAL FIELDS SEARCHED (Int.Cl.7) H03L H03D |
| A | EP 0 523 886 A (NAT SEMICONDUCTOR CORP) 20 January 1993 (1993-01-20) * abstract; figure 1 * | 4-7,14, 15 | |

The present search report has been drawn up for all claims

| Place of search | Date of completion of the search | Examiner |
|---|---|---|
| MUNICH | 5 September 2003 | Boudet, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 03 42 5274

This annex lists the patent family members relating to the patent documents cited in the above-mentioned European search report.
The members are as contained in the European Patent Office EDP file on
The European Patent Office is in no way liable for these particulars which are merely given for the purpose of information.

05-09-2003

| Patent document cited in search report | | Publication date | Patent family member(s) | | Publication date |
|---|---|---|---|---|---|
| US 5659263 | A | 19-08-1997 | EP<br>JP | 0798849 A1<br>10093649 A | 01-10-1997<br>10-04-1998 |
| US 3970868 | A | 20-07-1976 | NONE | | |
| US 5781036 | A | 14-07-1998 | EP<br>JP<br>WO | 0972338 A1<br>2001518249 T<br>9844624 A1 | 19-01-2000<br>09-10-2001<br>08-10-1998 |
| EP 0523886 | A | 20-01-1993 | US<br>DE<br>DE<br>EP<br>JP<br>JP<br>KR | 5239561 A<br>69214888 D1<br>69214888 T2<br>0523886 A1<br>3263436 B2<br>5291946 A<br>230611 B1 | 24-08-1993<br>05-12-1996<br>15-05-1997<br>20-01-1993<br>04-03-2002<br>05-11-1993<br>15-11-1999 |

For more details about this annex : see Official Journal of the European Patent Office, No. 12/82